# EUROPEAN PATENT APPLICATION

(11) **EP 4 037 188 A1**
(43) Date of publication of application: **03.08.2022**
(21) Application number: 21154418.4
(22) Date of filing: 29.01.2021
(51) Int. Cl.: H03K 17/12, H02M 1/088, H03K 17/16

(54) **SEMICONDUCTOR UNIT WITH ASYMMETRICALLY ARRANGED COMMON MODE CHOKES ON GATE DRIVER OUTPUT SIDE**

(71) Applicant: ABB Schweiz AG, 5400 Baden (CH)
(72) Inventor: Burkart, Ralph Mario, 8037 Zürich (CH); Kieferndorf, Frederick, 5400 Baden (CH); Park, Ki-Bum, 5442 Fislisbach (CH); Grecki, Filip, 5406 Rütihof (CH); Bahmani, Amin, 5018 Erlinsbach (CH); Abrach, Stefan, 8005 Zürich (CH); Luescher, Matthias, 5728 Gontenschwil (CH)
(74) Representative: Qip Patentanwälte Dr. Kuehn & Partner mbB

(57) **Abstract**

A semiconductor unit (10) comprises a first semiconductor switch (16a) and a second semiconductor switch (16b), which are connected in parallel; and a gate driver circuit (14) for the first semiconductor switch (16a) and the second semiconductor switch (16b); wherein the gate driver circuit (14) comprises at least one amplifier (30) for receiving a gate signal and for supplying a gate of the first semiconductor switch (16a) via a first gate output (52a) and for supplying a gate of the second semiconductor switch (16b) via a second gate output (52b) with a gate voltage; wherein the gate driver circuit (14) comprises a first reference potential output (62a) connected to a negative input of the first semiconductor switch (16a) and a second reference potential output (62b) connected to a negative input of the second semiconductor switch (16b); wherein the gate driver circuit (14) comprises a common mode choke (28) for coupling the first gate output (52a) and the first reference potential output (62a) via an impedance for a common mode current through the first gate output (52a) and the first reference potential output (62a); wherein the second gate output (52b) and the second reference potential output (62b) are coupled with a lesser common mode impedance.

## Description

### FIELD OF THE INVENTION

The invention relates to a semiconductor unit with at least two semiconductor switches.

### BACKGROUND OF THE INVENTION

Hard-paralleling of semiconductor switches is a widely adopted strategy to increase the power rating of a switched-mode power electronic converter. Hard-paralleling may be achieved by short-circuiting the individual semiconductor switches at their power terminals. One challenge of hard-paralleling lies in balancing of the individual switch currents during the on-state (static balancing) and during the switching transients (dynamic balancing). A current imbalance may lead to a non-equal power loss distribution and higher temperatures in the semiconductor switches with higher currents. In order not to exceed the maximum junction temperature in any of the semiconductor switches, derating of the total current capability may become necessary, which may result in higher costs, when compared to balanced operation.

For operating hard-paralleled semiconductor switches, a suitable gate driver is needed. Active gate driver concepts sense the currents and voltages in the paralleled semiconductor switches in order to adjust the individual gate voltages such that balanced conditions are achieved. Passive gate driver concepts apply a fixed gate voltage waveform that does not rely on feedback. Passive gate driver concepts are usually preferred due to their simplicity and low cost.

As an example for a passive gate driver concept, WO 2019/012038 A1 shows two semiconductor switches in parallel with two common mode chokes, each of which is arranged on the input side of an amplifier for providing the gate signal to a respective semiconductor switch.

There may be stringent requirements for the parasitic leakage inductance of the CM chokes. High values of the inductance may lead to undesired oscillations in the gate path whereas unequal values due to tolerances may introduce asymmetries between the gate voltage waveforms. Furthermore, common mode chokes are subject to pulsed currents with high average values. All these factors impose restrictions and thus complicate the design of gate drivers with common mode chokes.

### DESCRIPTION OF THE INVENTION

When hard-paralleling two or more half bridges, in a passive gate driver concept with common mode chokes, additional current loops in the power supplies of the gate drivers may be generated. These current loops have to be considered, when designing the gate driver circuit.

It is an objective of the invention to provide a simple and effective solution to equalize and reduce the switching losses of paralleled semiconductor switches.

This objective is achieved by the subject-matter of the independent claim. Further exemplary embodiments are evident from the dependent claims and the following description.

The invention relates to a semiconductor unit, which comprises a first semiconductor switch and a second semiconductor switch, which are connected in parallel. It is possible that the semiconductor unit comprises more than two semiconductor switches, which are connected in parallel. A semiconductor switch may be a thyristor or transistor, such as an IGBT, MOSFET, etc.

The semiconductor unit may be a power semiconductor unit and/or the semiconductor switches may be power semiconductor switches. It has to be noted that the term "power" may refer to devices adapted for processing voltages of more than 100 V and/or 10 A. For example, a voltage rating for a power semiconductor switch used in a power semiconductor unit may range between 600 V and 10 kV.

The semiconductor unit furthermore comprises a gate driver circuit for the first semiconductor switch and the second semiconductor switch. The gate driver circuit comprises at least one amplifier for receiving a gate signal and for supplying a gate of the first semiconductor switch via a first gate output and for supplying a gate of the second semiconductor switch via a second gate output with a gate voltage. The gate signal, which may be an on-and-off-signal, may be provided by a controller of the semiconductor unit.

The gate driver circuit further comprises a first reference potential output connected to a negative input of the first semiconductor switch and a second reference potential output connected to a negative input of the second semiconductor switch.

The gate driver circuit further comprises a common mode choke for coupling the first gate output and the first reference potential output via an impedance for a common mode current through the first gate output and the first reference potential output.

Contrary to this, the second gate output and the second reference potential output are coupled with a lesser common mode impedance, which may be substantially less than the common mode impedance for the first gate output and the first reference potential output.

The second gate output and the second reference potential output may be coupled with a common mode impedance that is less than 10% or even less than 1% of the common mode impedance the first gate output and the first reference potential output.

This may be achieved with no common mode choke or no active common mode choke, which is connected into the second gate output and the second reference potential output. The second gate output and the second reference potential output may be directly connected to the second semiconductor switch.

One or more common mode chokes may be asymmetrically arranged in the gate driver circuit. One or more common mode chokes may be solely interconnected into the outputs of the gate driver circuit. The outputs of the second gate driver may be directly connected to the second semiconductor switch. This reduces parasitic current loops in the power supply of the gate driver circuit and improves the switching behavior of the semiconductor unit.

A coupling with no common mode or a substantially lesser common mode impedance may be achieved with a direct electrical connection without any coupled inductors in the outputs of the gate driver circuit.

In general, the current through the outputs of the gate driver circuit for each semiconductor chip may be seen as a two-pole current. A common mode current may be seen as the average of the sum of the pole currents, i.e. the current through the outputs. This common mode current may be limited and/or reduced by the common mode choke. The impedance of the common mode choke may be an impedance for damping a time derivative of the common mode current. Thus, the impedance may damp the common mode voltage of the common mode current.

It has to be noted that also a common mode choke may be present in the outputs for the second semiconductor switch. However, this common mode choke may be bypassed and/or connected to the outputs, such that no common mode impedance is present.

The semiconductor unit may comprise more than two semiconductor switches connected in parallel. In this case, for at least one of the semiconductor switches, no or nearly no common mode coupling is provided in between the corresponding outputs. For the remaining semiconductor switches, a common mode choke may be provided for coupling the respective outputs via an impedance for a common mode current through the respective outputs.

When the semiconductor unit comprises more than two semiconductor switches connected in parallel, it may be that solely one of the semiconductor switches in a parallel connection is configured without and/or with bypassed common mode chokes. All other semiconductor switches may be configured with an active common mode choke, such as described above.

According to an embodiment of the invention, the gate driver circuit comprises a single amplifier for the first semiconductor switch and the second semiconductor switch, wherein an amplifier output of the single amplifier is connected to the first gate output and the second gate output. Both paralleled semiconductor switches may be supplied with a gate voltage by the same amplifier.

According to an embodiment of the invention, the gate driver circuit comprises a first amplifier for the first semiconductor switch and a second amplifier the second semiconductor switch, wherein an amplifier output of the first amplifier is connected to the first gate output and an amplifier output of the second amplifier is connected to the second gate output. There may be a separate amplifier for each semiconductor switch.

According to an embodiment of the invention, the at least one amplifier comprises a positive supply voltage input, a negative supply voltage input and a gate signal input for receiving the gate signal. The at least one amplifier may be adapted for supplying the gate of the respective semiconductor switch with the gate voltage by connecting the gate output with one of the positive supply voltage input and the negative supply voltage input.

The positive supply voltage input and the negative supply voltage input of each amplifier may be supplied with a constant voltage of for example +15 V and - 15 V. The gate signal, which may be an on-and-off-signal, may be provided by a controller of the semiconductor unit. This controller also may provide a reference potential input, which is connected to the reference potential outputs. The reference potential outputs are connected with the negative outputs of the semiconductor switches. The reference potential input potential may have a voltage of 0 V per definition. The positive supply voltage input, the negative supply voltage input, the gate signal input and the reference potential input may be seen as auxiliary inputs of the gate driver circuit.

According to an embodiment of the invention, the gate driver circuit furthermore comprises a power supply for supplying the amplifiers via the positive supply voltage input and the negative supply voltage input.

According to an embodiment of the invention, the power supply comprises an isolation transformer supplying the positive supply voltage input and the negative supply voltage input of the amplifiers. The power supply may comprise one or more isolation transformers, which supply the gate drivers with power and which are supplied by a power source.

According to an embodiment of the invention, the isolation transformer is connected via a further amplifier with a power source.

According to an embodiment of the invention, a first gate resistor circuit is interconnected into the first gate output and a second gate resistor circuit is interconnected into the second gate output. With the gate resistor circuits the voltage applied to the gate may be adjusted.

According to an embodiment of the invention, at least one of the first gate resistor circuit and the second gate resistor circuit comprises a gate resistor connected in parallel with a series connection of a diode and a further gate resistor. In such a way, the negative voltage and the positive voltage applied to the gate may be adjusted independently from each other.

According to an embodiment of the invention, the common mode choke is interconnected between a gate resistor circuit and the first gate output. In other words, the common mode choke may be positioned directly before the semiconductor switch.

According to an embodiment of the invention, the gate driver circuit comprises a reference potential input. The first reference potential output and the second reference potential output are connected via a connection point to the reference potential input. The reference potential input may be split up into two reference potential outputs. The common mode choke may be provided between the connection point and the first reference potential output. Again, the common mode choke may be positioned directly before the semiconductor switch.

According to an embodiment of the invention, a first reference potential resistor is interconnected into the first reference potential output and a second reference potential resistor is interconnected into the second reference potential output. The first reference potential resistor may be positioned between the connection point and the common mode choke.

According to an embodiment of the invention, the common mode choke comprises a single core with windings interconnected into first gate output and the first reference potential output. A first winding on the core may be interconnected in the first gate output. A second winding on the core may be interconnected in the first reference potential output.

According to an embodiment of the invention, the gate driver circuit comprises a second common mode choke interconnected into the second gate output and the second reference potential output, wherein the common mode choke is at least partially bypassed. The common mode choke may be at least partially bypassed for directly connecting at least some of the outputs with the first semiconductor switch. Partially bypassing may result in a lower or nearly no common mode impedance.

According to an embodiment of the invention, at least one winding of the second common mode choke is bypassed and/or short-circuited. It may be that both outputs have bypassed windings.

According to an embodiment of the invention, two windings of the second common mode choke are series connected and are interconnected into one of the second gate output and the second reference potential output. Also in this way, a common mode impedance is avoided or at least reduced. The series connection of the two windings of the second common mode choke may equalize stray inductances for the semiconductor switches, which may effects the differential mode behavior of the switches.

According to an embodiment of the invention, the semiconductor unit comprise a first half bridge and a second half bridge, wherein the first half bridge comprising a first high side semiconductor switch and a first low side semiconductor switch, which are connected in series, wherein the second half bridge comprises a second high side semiconductor switch and a second low side semiconductor switch, which are connected in series. The high side semiconductor switches are connected in parallel and the low side semiconductor switches are connected in parallel.

The paralleled high side switches and/or the paralleled low side switches may be provided with gate drivers and common mode chokes as described above.

Each of the first and the second half bridge may be provided by a semiconductor module. Also both half bridges may be provided by a semiconductor module. A semiconductor module may be any device that mechanically and electrically interconnects two or more semiconductor switches and their electrical interconnections. Usually, a semiconductor module comprises a housing for accommodating the two or more semiconductor switches and/or their electrical interconnections, which housing also may provide inputs for electrical interconnecting the power semiconductor unit with other power semiconductor units and/or, for example, the circuitry of an electrical converter.

The first half bridge and the second half bridge may be hard-paralleled, for example via their power terminals, which may be provided by the housing. It is possible that more than two half bridges are hard-paralleled.

According to an embodiment of the invention, the gate driver circuit comprises a high side gate driver circuit and a low side gate driver circuit. The high side gate driver circuit comprises a common mode choke for coupling a first gate output and a first reference potential output for the first high side semiconductor switch with a first common mode impedance, which may be provided by a first common mode choke. A second gate output and a second reference potential output for the second high side semiconductor switch are coupled with a lesser common mode impedance.

The low side gate driver circuit comprises a common mode choke for coupling a first gate output and a first reference potential output for the first low side semiconductor switch with a second common mode impedance, which may be provided by a second common mode choke. A second gate output and a second reference potential output for the second low side semiconductor switch are coupled with a lesser common mode impedance.

The arrangement on the high side and on the low side may be as described above and below.

According to an embodiment of the invention, the power supply comprises a high side isolation transformer supplying the positive supply voltage input and the negative supply voltage input of the high side gate driver circuit. Accordingly, the power supply comprises a low side isolation transformer supplying the positive supply voltage input and the negative supply voltage input of the low side gate driver circuit.

According to an embodiment of the invention, the high side isolation transformer and the low side isolation transformer are connected via a further amplifier with a power source.

These and other aspects of the invention will be apparent from and elucidated with reference to the embodiments described hereinafter.

### BRIEF DESCRIPTION OF THE DRAWINGS

The subject-matter of the invention will be explained in more detail in the following text with reference to exemplary embodiments which are illustrated in the attached drawings.
Fig. 1 schematically shows a semiconductor unit with symmetrically arranged common mode chokes.
Fig. 2 schematically shows a semiconductor unit with asymmetrically arranged common mode chokes according to an embodiment of the invention.
Fig. 3A schematically shows a semiconductor unit with a single amplifier according to an embodiment of the invention.
Fig. 3B schematically shows a semiconductor unit with two amplifiers according to an embodiment of the invention.
Fig. 4A to 4E schematically show embodiments of bypassed common mode chokes according to embodiments of the invention.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

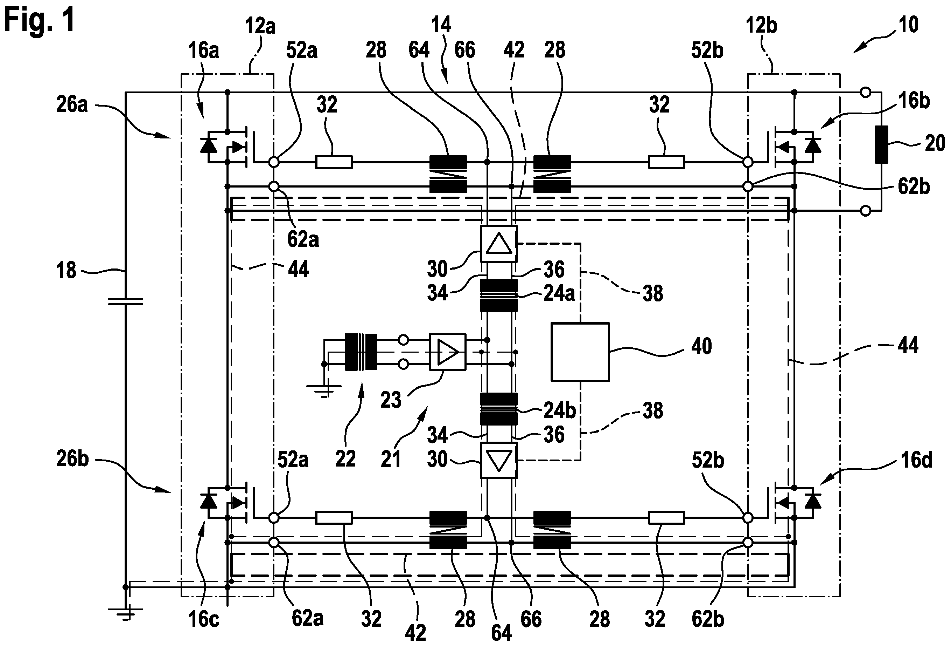

Fig. 1 shows a 10 comprising two half bridges 12a, 12b and a gate driver circuit 14.

Each of the half bridges 12a, 12b comprises two semiconductor switches 16a, 16c (or 16b, 16d), which are series connected. Each of the half bridges 12a, 12b may be provided by a semiconductor module. The semiconductor switches 16a, 16b, 16c, 16d may be MOSFETs, IGBTs or thyristors. As shown, a semiconductor switch 16a, 16b, 16c, 16d may comprise a switching device and an antiparallel freewheeling diode.

The half bridges 12a, 12b are connected in parallel, i.e. the ends and the midpoints of the two high side semiconductor switches 16a, 16b are connected with each other. The same applies to the low side semiconductor switches 16c, 16d. The half bridges 12a, 12b are connected to a DC voltage source 18 (here a capacitive DC link) via the endpoints and an AC load 20, for example via the midpoint and one endpoint.

The gate driver circuit 14 comprises a power supply 21 with power source 22 and an amplifier 23 connected thereto, which supplies the primary sides of two isolating transformers 24a, 24b. The primary sides of the isolating transformers 24a, 24b are connected in parallel.

The gate driver circuit 14 further comprises a high side gate driver circuit 26a and low side gate driver circuit 26b, each of which comprises two common mode chokes 28, and an amplifier 30, which on an output side is connected to both common mode chokes 28 and on the input side is connected to the respective transformer 24a, 24b. A gate resistor circuit 32 is connected between the common mode choke 28 and the respect vice switch 16a, 16b, 16c, 16d, which is supplied by the respective amplifier 30. Other elements such as gate driver rectifiers, additional converters, capacitors, protective elements, etc. may be integrated in the gate driver circuit 14 but are omitted in this description.

Each amplifier 30 has a positive supply voltage input 34, a negative supply voltage input 36 and a gate signal input 38. At its output side, each amplifier 30 is connected via the common mode choke 28 and the gate resistor circuit 32 with the gate of the respective semiconductor switch 16a, 16b, 16c, 16d and is connected to a negative output of the semiconductor switch 16a, 16b, 16c, 16d. A gate signal can be provided to the gate signal input 38 of the amplifier 30, which then may connect the gates of the semiconductor switches 16a, 16b (or 16c, 16d) either to the positive supply voltage input 34, a negative supply voltage input 36.

The gate signal is provided by a controller 40, which generates a gate signal for the high side gate driver circuit 26a and a further gate signal for the low side gate driver circuit 26b.

The positive supply voltage input 34 and the negative supply voltage input 36 of the high side gate driver circuit 26a and/ the high side amplifier 30 are connected to the secondary winding of the high side isolation transformer 24a. The positive supply voltage input 34 and the negative supply voltage input 36 of the low side gate driver circuit 26b and the low side amplifier 30 are connected to the secondary winding of the low side isolation transformer 24b.

On both the high side and the low side, an output 64 of the amplifier 30 is connected to a first gate output 52a for the semiconductor switch 16a (or 16c) and to a second gate output 52b for the semiconductor switch 16b (or 16d). A first reference potential output 62a for the semiconductor switch 16a (or 16c) and a second reference potential output 62b for the semiconductor switch 16b (or 16d) are connected via a connection point 66 with a reference potential, which may be provided by the amplifier 30 or a further device (see below).

Each common mode choke 28 is interconnected in a gate output 52a, 52b and a reference potential output 62a, 62b for a semiconductor switch 16a, 16b, 16c, 16d. Each common mode choke 28 is adapted for coupling the gate output 52a, 52b and the reference potential output 62a, 62b via an impedance for a common mode current through the gate output 52a, 52b and the reference potential output 62a, 62b.

Fig. 1 furthermore shows circulating current loops 42, 44 of the gate driver circuit 14. The placement of the common mode chokes 28 allows to suppress circulating currents in the loops 42 defined by the emitter paths between the half bridges 12a, 12b. The voltages in the loops 42 that are ideally taken by the common mode chokes 28 may be for example a result of unequal bus bar stray inductances, which are interconnecting the terminals of the half bridges 12a, 12b.

However, in addition to the loops 42, unintended parasitic loops 44 are present between a high-side and a low-side of the half bridges 12a, 12b. The parasitic loops 44 are driven by the high-side/low-side voltage commutations of the semiconductor switches 16a, 16b, 16c, 16d, which involves a charging and discharging of the non-negligible stray capacitances of the auxiliary isolation transformers 24a, 24b. Corresponding unintended parasitic loops 44 would be present, when solely the high side or low side part of the circuit would be present.

An additional high-side/low-side path also exists through ground which may involve a supply transformer of the power source 22.

At typical frequency ranges of the voltage transients, the impedance of the common mode chokes 28 is usually non-negligible, when compared to the equivalent impedance of the involved parasitic stray capacitances of the isolation transformers 24a, 24b. A considerable share of the transient voltage may apply across the common mode chokes 28 instead of being taken by the isolation transformers 24a, 24b.

The high-side/low-side loops 44 may result in a more complex magnetic design of the common mode chokes 28, since a saturation of the common mode chokes 28 should be avoided. Furthermore, an upper limit of the common mode choke inductances may be strongly constrained. Increased losses may be caused due to the increased voltage and current load on the common mode chokes. Additionally, a peak voltage/insulation and peak flux requirements may increase with the switching speed and are thus more challenging to fulfil with fast semiconductors, such as SiC switches.

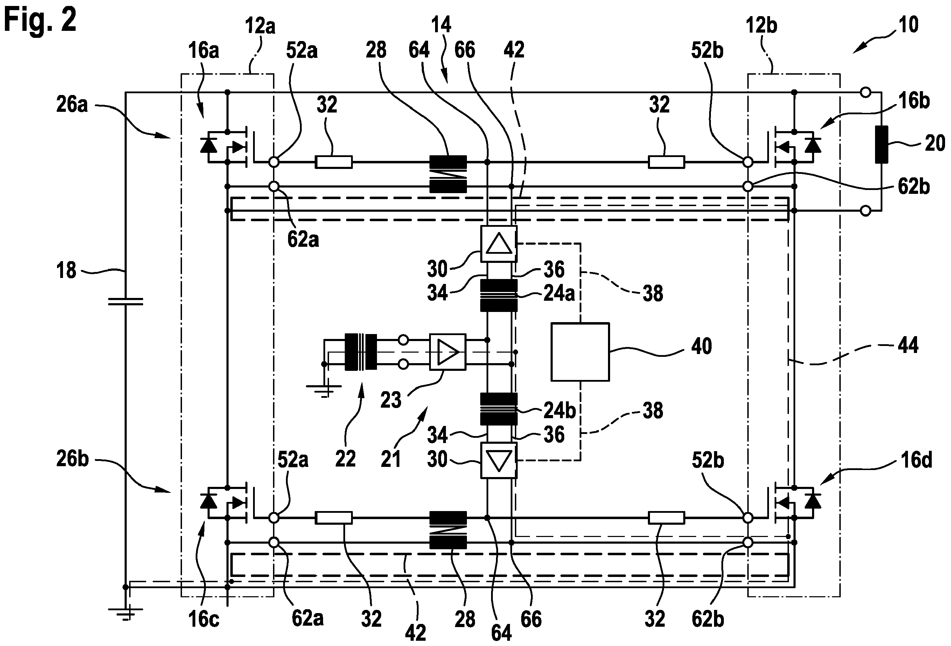

In Fig. 2, a semiconductor unit 10 with a gate driver circuit 14 having asymmetrically arranged common mode chokes 28 is shown. For the first half bridge 12a, common mode chokes 28 as in Fig. 1 are present. Each of the low side gate driver circuit 26a and the high side gate driver circuit 26b comprises a common mode choke 28 for coupling the first gate output 52a and the first reference potential output 62a via an impedance for a common mode current through the first gate output 52a and the first reference potential output 62a. For the second half bridge 12b, different common mode chokes 28 (such as in Fig. 1) with a substantially lower common mode impedance (such as less than 10% of the common mode impedance of the common mode choke 28), no common mode chokes (such as shown in Fig. 2) or bypassed common mode chokes 28' (see below) are present. For each of the low side gate driver circuit 26a and the high side gate driver circuit 26b the second gate output 52b and the second reference potential output 62b are coupled with a lesser common mode impedance, nearly no common mode impedance or no common mode impedance.

As shown in Fig. 2, this may be achieved by directly connecting the amplifier output 64 with the second gate output 52b and the connection point 66 with the second reference potential output 62b.

In general, the semiconductor unit 10 may comprise more than two half bridges 12a, 12b. In this case, for at least one of the half bridges 12b, the second gate output 52b and the second reference potential output 62b are coupled with a lesser common mode impedance, nearly no common mode impedance or no common mode impedance. For the remaining half bridges 12a, a common mode choke 28 may be present for coupling the first gate output 52a and the first reference potential output 62a via an impedance for a common mode current through the first gate output 52a and the first reference potential output 62a.

When the semiconductor unit 10 comprises more than two half bridges 12a, 12b (say N), it may be that solely one of the half bridges 12b is configured with different, bypassed and/or missing common mode chokes 28'. The other N-1 half bridges 12a may be configured with an active common mode choke 28.

One common mode choke 28 on the high side and/or the low side of one half bridge 12b may be short-circuited and/or bypassed, i.e. the implementation of *N*-1 common mode chokes 28 only, where N denotes the number of hard-paralleled half bridges 12a, 12b.

As shown in Fig. 2, the different, missing and/or not active common choke in one of the parallel gate driver paths creates a current loop 44 with low impedance which allows to charge/discharge the parasitic capacitances of the isolation transformers 24a, 24b in a largely unconstrained manner. In such a way, transient voltage caused by the semiconductor switches 16a, 16b, 16c, 16d may be fully taken by the dedicated isolation transformer 24a, 24b instead of partly by the common mode chokes 28, which usually are not designed for this purpose. Such a current loop 44 with low impedance also would be present, when solely the high side or the low side part of the circuit would be present.

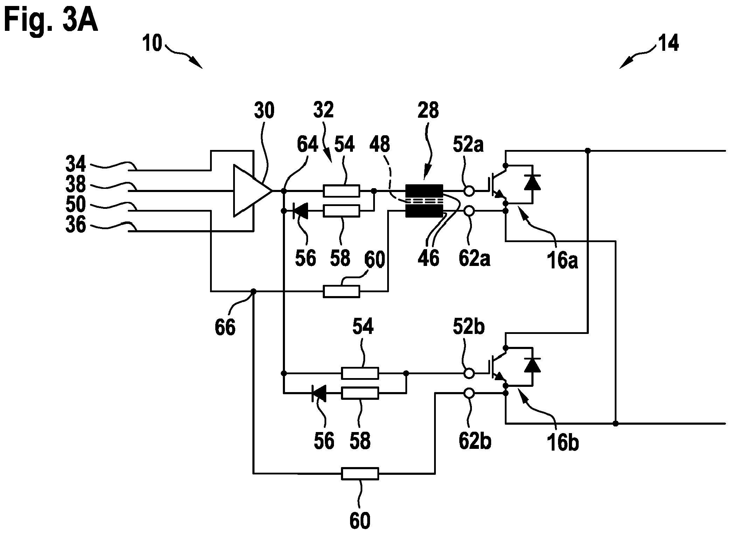

Fig. 3A shows a semiconductor unit 10 with gate driver circuit 14, which comprises a single amplifier 30 for the first semiconductor switch 16a and the second semiconductor switch 16b. The high side gate driver circuit 26a and the low side gate driver circuit of Fig. 2 may be designed as the gate driver circuit 14 of Fig. 3A.

The amplifier 30 comprises a positive supply voltage input 34, a negative supply voltage input 36 and a gate signal input 38 for receiving the gate signal. The amplifier 30 is adapted for supplying the gate of the respective semiconductor switch 16a, 16b with the gate voltage by connecting the gate outputs 52a, 52b with one of the positive supply voltage input 34 and the negative supply voltage input 36.

The amplifier output 64 of the single amplifier 30, which outputs the gate voltage, is connected via two gate resistor circuits 32 to the first gate output 52a and the second gate output 52b. Each gate resistor circuit 32 may comprise a gate resistor 54 connected in parallel with a series connection of diode 56 and a further gate resistor 58. This makes it possible to provide a gate resistor circuit 32 that depends on the positive and negative side of the voltage supplied to the gate output 52.

The amplifier 30 is adapted for connecting its output 64, the gate outputs 52a and the gate of the semiconductor switch 16a, 16b with the positive supply voltage input 34 and the negative supply voltage input 36 based on the gate signal provided via the gate signal input 38. For example, when the gate signal is positive, then the amplifier 30 connects its output 64, the gate outputs 52a, 52b to the positive supply voltage input 34 and when the gate signal is negative, then the amplifier 30 connects its output 64, the gate output 52 to the negative supply voltage input 36.

Fig 3A further shows that a reference potential input 50, for example connected to the controller 40, is connected to a connection point 66, to which the reference potential outputs 62a, 62b are connected. A resistor 60 may be interconnected into each reference potential output 62a, 62b. Each reference potential output 62a, 62b is connected to the negative input and/or emitter of the semiconductor switch 16a, 16b.

A common mode choke 28 which comprises two windings 46, which are coupled via a common core 48, is interconnected into the first gate output 52a and the first reference potential output 62a. The common mode choke 28, which may be arranged between the gate resistor circuit 32, the resistor 60 and the semiconductor switch 16a, couples the first gate output 52a and the first reference potential output 62a via an impedance for a common mode current through these outputs 52a, 62b. A winding 46 of the common mode choke 28 is interconnected into the respective output 52a, 62a.

The second gate output 52b and the second reference potential output 62b are coupled with a substantially lesser common mode impedance, or as shown here, are not coupled at all. The gate resistor circuit 32 and the resistor 60 are directly connected to the semiconductor switch 16b.

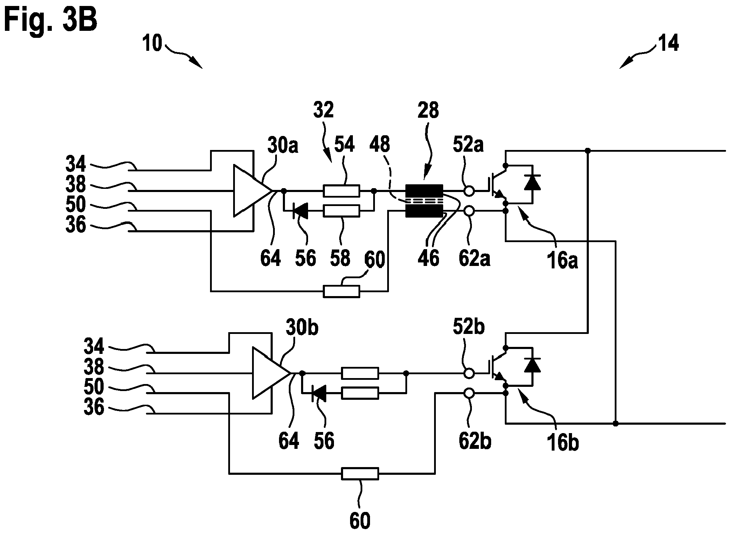

Fig. 3B shows a semiconductor unit 10 with gate driver circuit 14, which comprises a first amplifier 30a for the first semiconductor switch 16a and a second amplifier 30b for the second semiconductor switch 16b. The high side gate driver circuit 26a and the low side gate driver circuit of Fig. 2 also may be designed as the gate driver circuit 14 as shown in Fig. 3B.

The amplifiers 30a, 30b may be designed as the amplifier of Fig. 3A. The amplifier output 64 of the first amplifier 30a is connected via a gate resistor circuit 32 to the first gate output 52a and the amplifier output 64 of the second amplifier 30b is connected to the second gate output 52b.

The gate driver circuit 14 of Fig. 3B shows two reference potential inputs 50, which however (such as in Fig. 3A) also may be connected to the same reference potential provided by the controller 40.

In Fig. 3B, analogously as in Fig. 3A, a common mode choke 28 couples the first gate output 52a and the first reference potential output 62a and the second gate output 52b and the second reference potential output 62b are coupled with a substantially lesser common mode impedance, or as shown here, are not coupled at all.

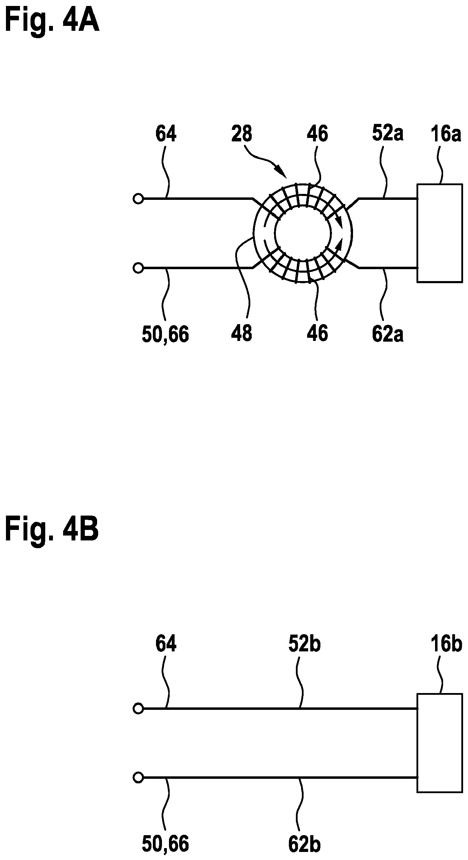

Fig. 4A shows an embodiment of a common mode choke 28 interconnected into the first gate output 52a and the reference potential output 62a. The common single core 48 comprises two windings 46 for each of the first gate output 52a and the reference potential output 62a.

Fig 4B to Fig. 4E shows embodiments, how a connection of the amplifier output 64 with the second gate output 52b and a connection of the reference potential input 50 (and/or the connection point 66) with the reference potential output 62b can be achieved with nearly no or no common mode coupling.

Fig. 4B schematically shows that the amplifier output 64 is directly connected with the second gate output 52b and that the reference potential input 50 (and/or the connection point 66) is directly connected with the reference potential output 62b. There is no impedance provided by a common mode choke. A present common mode choke may be disconnected from all the points 64, 52b, 50, 66, 62b.

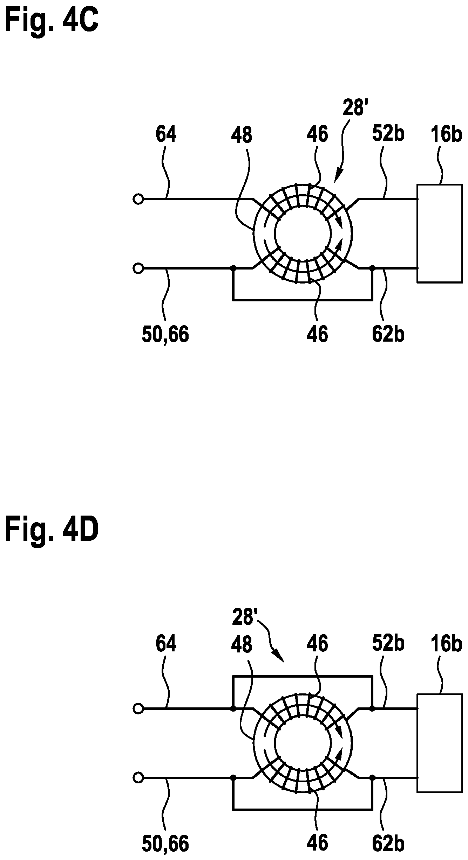

Fig. 4C shows the same arrangement as in Fig. 4A, however with a bypassed common mode choke 28'. One of the windings 46 is bypassed, for example with a zero ohm resistor and/or resistance. The remaining winding 46 is not bypassed. As shown in Fig. 4D, it is possible that both windings 46 are bypassed, for example with a zero ohm resistor and/or resistance. At least one winding 46 of the common mode choke 28', which is interconnected into one of the outputs 52b, 62b, may be bypassed.

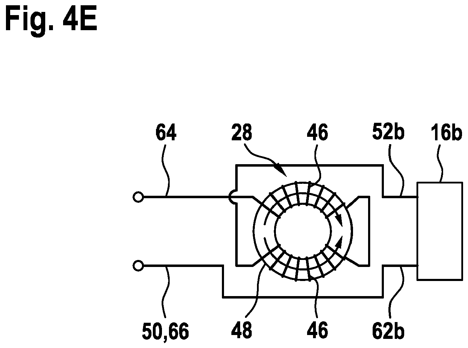

Fig. 4E shows a further example of a bypassed common mode choke 28', wherein two windings 46 of the common mode choke 28' are series connected and are interconnected into the second gate output 52b or the reference potential output 62b. The other one of the second gate output 52b or the reference potential output 62b is directly connected, such as described with respect to Fig. 4B.

In general, the common mode choke 28' may be at least partially bypassed for directly connecting the second gate output 52b to the amplifier output 64 and/or the reference potential output 62b to the reference potential input 50 and/or the connection point 66.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practicing the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

- 10: semiconductor unit
- 12a: first half bridge
- 12b: second half bridge
- 14: gate driver circuit
- 16a: first high side semiconductor switch
- 16b: second high side semiconductor switch
- 16c: first low side semiconductor switch
- 16d: second low side semiconductor switch
- 18: DC voltage source
- 20: AC load
- 21: power supply
- 22: power source
- 23: amplifier
- 24a: high side isolating transformer
- 24b: low side isolating transformer
- 26a: high side gate driver circuit
- 26b: low side gate driver circuit
- 28: common mode choke
- 28': bypassed common mode choke
- 30: amplifier
- 30a: first amplifier
- 30b: second amplifier
- 32: gate resistor circuit
- 34: positive supply voltage input
- 36: negative supply voltage input
- 38: gate signal input
- 40: controller
- 42: current loop
- 44: current loop
- 26b': second high side gate driver
- 26d': second low side gate driver
- 46: winding
- 48: core
- 50: reference potential input
- 52a: first gate output
- 52b: second gate output
- 54: gate resistor
- 56: diode
- 58: gate resistor
- 60: resistor
- 62a: first reference potential output
- 62b: second reference potential output
- 64: amplifier output
- 66: connection point

## Claims

1. A semiconductor unit (10), comprising:
a first semiconductor switch (16a) and a second semiconductor switch (16b), which are connected in parallel;
a gate driver circuit (14) for the first semiconductor switch (16a) and the second semiconductor switch (16b);
wherein the gate driver circuit (14) comprises at least one amplifier (30, 30a, 30b) for receiving a gate signal and for supplying a gate of the first semiconductor switch (16a) via a first gate output (52a) and for supplying a gate of the second semiconductor switch (16b) via a second gate output (52b) with a gate voltage;
wherein the gate driver circuit (14) comprises a first reference potential output (62a) connected to a negative input of the first semiconductor switch (16a) and a second reference potential output (62b) connected to a negative input of the second semiconductor switch (16b);
wherein the gate driver circuit (14) comprises a common mode choke (28) for coupling the first gate output (52a) and the first reference potential output (62a) via an impedance for a common mode current through the first gate output (52a) and the first reference potential output (62a);
wherein the second gate output (52b) and the second reference potential output (62b) are coupled with a lesser common mode impedance.

2. The semiconductor unit (10) of claim 1,
wherein the second gate output (52b) and the second reference potential output (62b) are coupled with a common mode impedance that is less than 10% of the common mode impedance the first gate output (52a) and the first reference potential output (62a).

3. The semiconductor unit (10) of one claim 1 or 2,
wherein the gate driver circuit (14) comprises a single amplifier (30) for the first semiconductor switch (16a) and the second semiconductor switch (16b);
wherein an amplifier output (64) of the single amplifier (30) is connected to the first gate output (52a) and the second gate output (52b).

4. The semiconductor unit (10) of one of claims 1 to 3,
wherein the gate driver circuit (14) comprises a first amplifier (30a) for the first semiconductor switch (16a) and a second amplifier (30b) for the second semiconductor switch (16b);
wherein an amplifier output (64) of the first amplifier (30a) is connected to the first gate output (52a) and an amplifier output (64) of the second amplifier (30b) is connected to the second gate output (52b).

5. The semiconductor unit (10) of one of the previous claims,
wherein the at least one amplifier (30) comprises a positive supply voltage input (34), a negative supply voltage input (36) and a gate signal input (38) for receiving the gate signal;
wherein the at least one amplifier (30) is adapted for supplying the gate of the respective semiconductor switch (16a, 16b) with the gate voltage by connecting the gate output (52a, 52b) with one of the positive supply voltage input (34) and the negative supply voltage input (36).

6. The semiconductor unit (10) of one of the previous claims,
wherein a first gate resistor circuit (32) is interconnected into the first gate output (52a);
wherein a second gate resistor circuit (32) is interconnected into the second gate output (52b);

7. The semiconductor unit (10) of claim 6,
wherein at least one of the first gate resistor circuit (32) and the second gate resistor circuit (32) comprises a gate resistor (54) connected in parallel with a series connection of a diode (56) and a further gate resistor (58).

8. The semiconductor unit (10) of one of the previous claims,
wherein the common mode choke (28) is interconnected between a gate resistor circuit (32) and the first gate output (52a).

9. The semiconductor unit (10) of one of the previous claims,
wherein the gate driver circuit comprises a reference potential input (50) and wherein the first reference potential output (62a) and the second reference potential output (62b) are connected via a connection point (66) to the reference potential input (50).
wherein the common mode choke is provided between the connection point (66) and the first reference potential output (62a).

10. The semiconductor unit (10) of claim 9,
wherein a first reference potential resistor (60) is interconnected into the first reference potential output (62a);
wherein a second reference potential resistor (60) is interconnected into the second reference potential output (62b).

11. The semiconductor unit (10) of one of the previous claims,
wherein the common mode choke (28, 28') comprises a single core (48) with windings (46) interconnected into first gate output (52a) and the first reference potential output (62a).

12. The semiconductor unit (10) of one of the previous claims,
wherein the gate driver circuit (14) comprises a second common mode choke (28') interconnected into the second gate output (52b) and the second reference potential output (62b);
wherein the common mode choke (28') is at least partially bypassed.

13. The semiconductor unit (10) of claim 12,
wherein at least one winding (46) of the second common mode choke (28') of the second gate driver (26b') is bypassed.

14. The semiconductor unit (10) of claim 12 or 13,
wherein two windings (46) of the second common mode choke (28') are series connected and are interconnected into one of the second gate output (52b) and the second reference potential output (62b).

15. The semiconductor unit (10) of one of the previous claims, comprising:
a first half bridge (12a) and a second half bridge (12b);
wherein the first half bridge (12a) comprising a first high side semiconductor switch (16a) and a first low side semiconductor switch (16c), which are connected in series;
wherein the second half bridge (12b) comprising a second high side semiconductor switch (16b) and a second low side semiconductor switch (16d), which are connected in series;
wherein the high side semiconductor switches (16a, 16b) are connected in parallel;
wherein the low side semiconductor switches (16c, 16d) are connected in parallel;
wherein the gate driver circuit (14) comprises a high side gate driver circuit (26a) and a low side gate driver circuit (26b)
wherein the high side gate driver circuit (26a) comprises a common mode choke (28) for coupling a first gate output (52a) and a first reference potential output (62a) for the first high side semiconductor switch (16a) with a common mode impedance;
wherein a second gate output (52b) and a second reference potential output (62b) for the second high side semiconductor switch (16b) are coupled with a lesser common mode impedance;
wherein the low side gate driver circuit (26b) comprises a common mode choke (28) for coupling a first gate output (52a) and a first reference potential output (62a) for the first low side semiconductor switch (16c) with a common mode impedance;
wherein a second gate output (52b) and a second reference potential output (62b) for the second low side semiconductor switch (16e) are coupled with a lesser common mode impedance.
